Europäisches Patentamt

European Patent Office

Office européen des brevets

(11) Veröffentlichungsnummer: **0 419 775 A2**

# EUROPÄISCHE PATENTANMELDUNG

(21) Anmeldenummer: 90112514.6

(51) Int. Cl.5: **H01L 31/048**, H01L 31/042

(22) Anmeldetag: 30.06.90

(30) Priorität: 03.05.90 DE 4014200
28.09.89 DE 3932290

(43) Veröffentlichungstag der Anmeldung:
03.04.91 Patentblatt 91/14

(84) Benannte Vertragsstaaten:
CH DE ES FR IT LI

(71) Anmelder: TELEFUNKEN SYSTEMTECHNIK
GMBH
Sedanstrasse 10
W-7900 Ulm (Donau)(DE)

(72) Erfinder: **Gochermann, Hans, Dipl.-Ing.**
**Am Meierhof 36**
**W-2081 Holm(DE)**
Erfinder: **Flödl, Helmut, Dipl.-Ing. (FH)**
**Panoramastrasse 17**
**W-7107 Bad Friedrichshall(DE)**

(74) Vertreter: **Salhoff, Roland, Dipl.-Ing.**
**TELEFUNKEN SYSTEMTECHNIK GMBH**
**Postfach 17 30**
**W-7900 Ulm (Donau)(DE)**

(54) Photovoltaischer rahmenloser Solargenerator.

(57) Photovoltaischer rahmenloser Solargenerator, vorzugsweise für eine Hochhausfassade, ein Dach, einen Wintergarten oderdergleichen, der in Kunststoff eingebettete Solarzellen, insbesondere Solarzellenlaminat, und als Abdeckung eine Glasscheibe aufweist. Ein optimaler Flächenwirkungsgrad wird dadurch erzielt, daß der Solargenerator (1, 1a) an seiner Rückseite (3, 24, 31) werksseitig mit Befestigungsprofilen (2, 20) versehen ist, und daß die Verbindung zwischen der Rückseite (3, 24, 21) und den Befestigungsprofilen (2, 20) über elastische Verbindungsstege (4) erfolgt. Die Befestigungsprofile (2, 20) können auf die Rückseite des Solargenerators (1, 1a) aufgeklebt sein.

FIG.1

EP 0 419 775 A2

# PHOTOVOLTAISCHER RAHMENLOSER SOLARGENERATOR

Die Erfindung betrifft einen photovoltaischen rahmenlosen Solargenerator, vorzugsweise für eine Hochhausfassade, ein Dach, einen Wintergarten oderdergleichen, der in Kunststoff eingebettete Solarzellen, insbesondere Solarzellenlaminat, und als Abdeckung eine Glasscheibe aufweist.

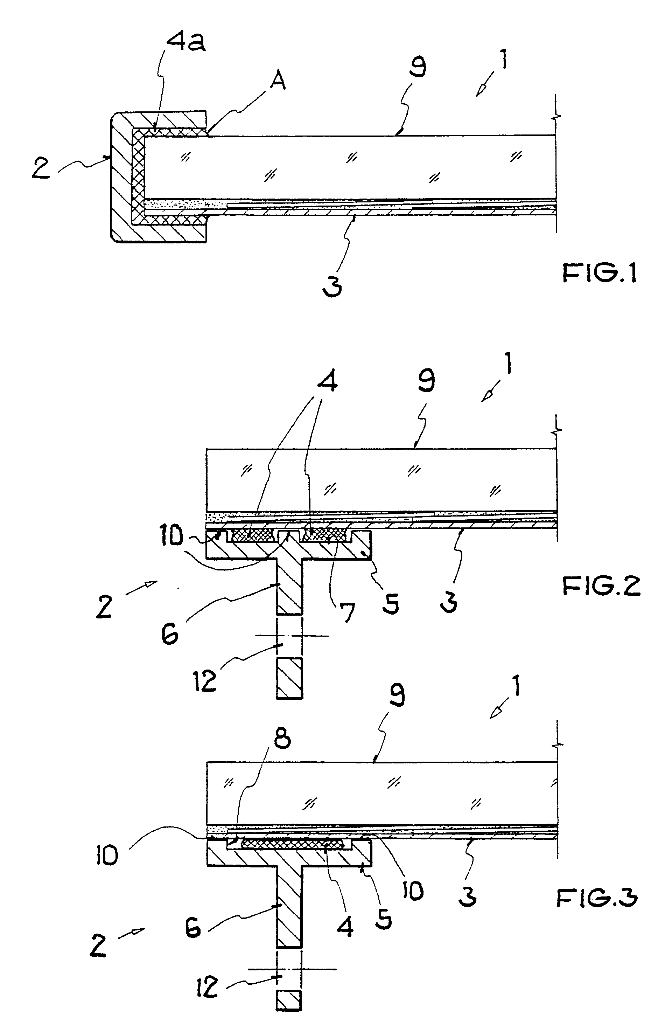

Die Figur 1 zeigt ein Solarzellenmodul mit Rahmen, wobei das Rahmenteil 2 U-förmig ausgebildet ist, so daß die Stirnseite sowie der Rand der Vorderseite 9 als auch der Rand der Rückseite 2 umgriffen wird. Die Verbindung zwischen dem Rahmenteil 2 und dem Solarzellenlaminat 1 wird über eine flächig aufgebrachte Klebstoffmasse 4a hergestellt. Eine solche Anordnung hat jedoch den Nachteil, daß ein Teil der vorderen Fläche 9 durch die von dem Rahmenteil 2 gebildete Umfassung nicht nutzbar ist. Im Verlauf des Betriebes eines solchen Solarzellenmoduls vergrößert sich sogar dieser Rand durch Schmutzteile, die sich im Bereich A des Überganges von dem Rahmenteil 2 zur unbedeckten Vorderseite 9 des Solarzellenlaminats 1 ansammeln.

Außerdem kommt es in diesem Verbund bei großen Temperaturschwankungen aufgrund unterschiedlicher Längenausdehnung an den Berührungsflächen zwischen dem Rahmenteil 2 und dem Solarzellenlaminat 1 zu Materialspannungen, die zu Schäden und auch zu Ausfällen beim Betrieb des Solarzellenmoduls führen können. Diese Materialspannungen bauen sich im wesentlichen zwischen dem beispielsweise aus Aluminium hergestellten Rahmenteil 2 und der die Vorderseite des Solarzellenlaminats 1 abdeckenden Glasscheibe auf, wo beispielsweise bei einer Temperaturdifferenz von $100^\circ$ C auf einer Länge von einem Meter eine Längendifferenz von ca. 1,5 mm auftritt.

Bekannt sind auch rahmenlose Solargeneratoren, die ebenfalls in Kunststoff eingebettete Solarzellen und als Abdeckung eine Glasscheibe aufweisen. Rahmenlose Solargeneratoren werden bekannterweise zur Gewinnung von elektrischer Energie auch an Fassaden oder Dächern von Häusern befestigt. Hierzu werden sie in Rahmen eingesetzt, die bauseitig angeordnet sind und Gummi- und Metallprofile zur Dichtung und Befestigung aufweisen. Diese Rahmen liegen notwendigerweise vorderseitig auf den Solargeneratoren zur Befestigung und Dichtung auf. Der relativ hohe Anteil des Rahmens an der Generatorfläche führt nachteiligerweise zu einer Verringerung des Generator-Flächenwirkungsgrades, (Generatorfläche zur Gesamtfläche aus den bauseitigen Rastermaßen). Zudem führen die hervorstehenden Profile zu partiellen Abschattungen bei schrägem Lichteinfall, was wiederum die Flächeneffizienz des Generators reduziert oder einen deutlichen Randabstand des Generators erfordert, d. h. die nutzbare Fläche des Generators wird nochmals kleiner.

Der Erfindung liegt die Aufgabe zugrunde, einen photovoltaischen Solargenerator der eingangs genannten Art zu schaffen, mit dem ein optimaler Flächenwirkungsgrad erzielt wird.

Die Aufgabe wird erfindungsgemäß dadurch gelöst, daß der Solargenerator an seiner Rückseite werksseitig mit Befestigungsprofilen versehen ist, und daß die Verbindung zwischen der Rückseite und den Befestigungsprofilen über elastische Verbindungsstege erfolgt.

Ein Vorteil der Erfindung liegt darin, daß die Solargeneratoren Stoß auf Stoß eingesetzt werden können und somit die Nominalfläche des bauseitigen Rasters insgesamt als aktive Generatorfläche nutzbar ist. Ein weiterer Vorteil ist, daß der Solargenerator in bestehende Verglasungsstrukturen integriert werden kann, wobei eine Verbesserung des architektonischen Gesamtbildes durch eine farblich homogene, ebene und großflächige Anordnung erzielt wird. Von Vorteil ist auch, daß bei der ebenflächigen Anordnung von Solargeneratoren und Scheiben der Reinigungsaufwand verringert wird, da infolge der rahmenlosen Solargeneratoren Bauteile, die eine Verschmutzung begünstigen, fehlen und somit der Selbstreinigungseffekt gegenüber in Rahmen eingesetzte Solargeneratoren erhöht wird. Weitere wesentliche Vorteile sind eine Verbesserung der Schalldämmung, eine gleichmäßigere Aufheizung der Generatoren, eine höhere Schlagregendichtigkeit und Kosteneinsparungen aufgrund werksseitiger Vorfertigung und weniger arbeitsaufwendiger Fertigstellung am Bau. Außerdem ist ein höheres Maß an Bewitterungsschutz (Korrosionsausschluß) für die Befestigungselemente gegeben, da diese alle hinter den Generatorscheiben liegen. Da die Verbindung bei dem erfindungsgemäßen Solarzellenmodul zwischen dem Rahmenteil und dem Solarzellenlaminat über einen elastischen Verbindungssteg erfolgt, sind beide Teile in geringem Maße gegeneinander verschiebbar, so daß durch Temperaturschwankungen bedingte Materialspannungen vernachlässigbar klein sind. Schließlich ergibt sich vorteilhafterweise auch eine einfache Montage des Rahmenteils sowie ein vereinfachter Einbau des Solarzellenlaminats in dieses Rahmenteil, was zu einer kostengünstigen Fertigung des Solarzellenmoduls führt.

Eine erfindungsgemäße Ausgestaltung der Erfindung geht dahin, daß die Befestigungsprofile auf die Rückseite des Solargenerators aufgeklebt sind, vorzugsweise durch die Verwendung eines Silikonklebers. Auch können zwischen der Rückseite des Solargenerators und den Befestigungsprofilen Abstandshalter, vorzugsweise elastische angeordnet sind.

Eine Weiterbildung der Erfindung ist gekennzeichnet durch U-förmige Befestigungsprofile, deren gegenüberliegende Schenkel an dem Solargenerator oder einer Fassade oderdergleichen befestigt sind. Auch ist die Verwendung von L-förmigen Befestigungsprofilen möglich.

Eine Ausgestaltung der Erfindung geht dahin, daß die Fugen zwischen Solargeneratoren und/oder Scheiben der Hochhausfassade, des Daches, des Wintergartens oderdergleichen mit einem Abstandshalter und/oder einer Dichtmasse ausgefüllt sind, vorzugsweise durch die Verwendung von Silikonklebern als Dichtmasse. Gemäß weiteren vorteilhaften Ausführungsformen des erfindungsgemäßen Solarzellenmoduls bestehen deren Rahmenteile aus einem T-Profil oder einem rechteckförmigen Profil. Hierbei weist bei einer bevorzugten Weiterbildung einer solchen Ausführungsform die an der Rückseite des Solarzellen laminats anliegende Fläche des Rahmenteils mehrere Aussparungen auf, die die elastischen Verbindungsstege zur Verbindung des Rahmenteils mit dem Solarzellenlaminat aufnehmen. Hierdurch können sich in optimaler Weise unterschiedliche Längendehnungen der beteiligten Materialien ausgleichen.

Bei einer weiteren vorteilhaften Weiterbildung eines erfindungsgemäßen Solarzellenmoduls ist die an der Rückseite des Solarzellenlaminats anliegende Fläche des Rahmenteils derart U-förmig ausgebildet, daß die beiden Schenkel auf der Rückseite aufstehen, wobei der verbleibende Zwischenraum, der durch die Öffnung in der U-Form und der Rückseite des Solarzellenlaminats gebildet wird, den elastischen Verbindungssteg zur festen Verbindung von Rahmenteil und Solarzellenlaminat aufnimmt. In vorteilhafter Weise wird hierbei eine weitere Vereinfachung des Einbaus des Solarzellenlaminats in das Rahmenteil erzielt.

Ferner wird bei einer bevorzugten Weiterbildung der Erfindung die Breite der Verbindungsstege kleiner als die Breite der Verbindungsstege aufnehmende Aussparungen bzw. Öffnungen und sind dort derart angeordnet, daß beiseitig an den Verbindungsstegen ein Zwischenraum verbleibt.

Schließlich besteht gemäß einer weiteren vorteilhaften Weiterbildung der Erfindung der elastische Verbindungssteg aus einer elastischen Klebstoffmasse. Als elastische Klebstoffmasse kann bei einer weiteren bevorzugten Ausführungsform der Erfindung ein Silikonkleber verwendet werden.

Im Folgenden soll anhand von Ausführungsbeispielen, die in den Figuren dargestellt sind, die Erfindung näher erläutert werden. Es zeigen:

Figur 2: ein Ausführungsbeispiel eines erfindungsgemäßen Solarzellenmoduls mit einem T-förmigen Rahmenteil,

Figur 3: eine vorteilhafte Weiterbildung der Ausführungsform des erfindungsgemäßen Solarzellenmoduls gemäß Figur 2,

Figur 4: eine Ausführungsform des erfindungsgemäßen Solarzellenmoduls mit einem rechteckförmigen Rahmenteil,

Figur 5: eine vorteilhafte Weiterbildung der Ausführungsform des erfindungsgemäßen Solarzellenmoduls gemäß Figur 4,

Figur 6: die Anordnung eines asymmetrischen Solargenerators und einer Scheibe an einem Fassadenpfosten im Schnitt, und

Figur 7: die Anordnung eines symmetrischen Solargenerators und einer Scheibe an einem Fassadenpfosten im Schnitt.

In den Figuren sind einander entsprechende Teile mit den gleichen Bezugszeichen versehen.

In der Querschnittsdarstellung der Ausführungsform des erfindungsgemäßen Solarzellenmoduls gemäß Figur 2 ist mit den Bezugzeichen 1 und 2 ein Solarzellenlaminat und ein T-förmiges Rahmenteil bezeichnet. Dieses Rahmenteil 2 besteht aus einem Querteil 5 und einem senkrechten Teil 6, wobei die äußere Fläche 10 des Querteils 5 mit der Rückseite 3 des Solarzellenlaminats 1 nur im Bereich des Randes der Rückseite 3 in Kontakt steht. Weiterhin sind auf der mit dem Solarzellenlaminat 1 in Kontakt stehenden Fläche 10 des Querteils 5 des T-förmigen Rahmenteils 2 rechteckförmige Aussparungen 7 vorgesehen, die jeweils einen elastischen Verbindungssteg 4 derart aufnehmen, daß beidseitig an den Verbindungsstegen 4 jeweils ein Zwischenraum in den Aussparungen 7 verbleibt, der von dem entsprechenden Verbindungssteg 4 nicht ausgefüllt wird. Außerhalb dieser Aussparungen berühren sich die Flächen 10 und 3 des Querteils 5 und des Solarzellenlaminats 1. Diese elastischen Verbindungsstege 4 stellen eine feste Verbindung zur Rückseite 3 des Solarzellenlaminats 1 her, wobei die Höhe der Verbindungsstege 4 so gewählt ist, daß aufgrund deren Elastizität das Solarzellenlaminat 1 gegenüber dem Rahmenteil 2 in geringem Maße verschiebbar ist. Hierdurch ist es möglich, daß bei hohen Temperaturschwankungen eine auf der Vorderseite 9 des Solarzellenlaminats 1 befindliche Glasscheibe weniger stark ausdehnen kann als das, beispielsweise aus Aluminium hergestellte Rahmenteil 2. Folglich können in dem Verbund von Solarzellenlaminat 1 und Rahmenteil 2 keine Materialspannungen auftreten. Die Verbindungsstege 4 bestehen aus einer elastischen Klebstoffmasse, beispielsweise aus Silikonkleber. Schließlich ist bei dieser Ausführungsform eines erfindungsgemäßen Solarzellenmoduls keine Berandung vorgesehen, so daß hierdurch die Glasfläche maximal ausgenützt wird.

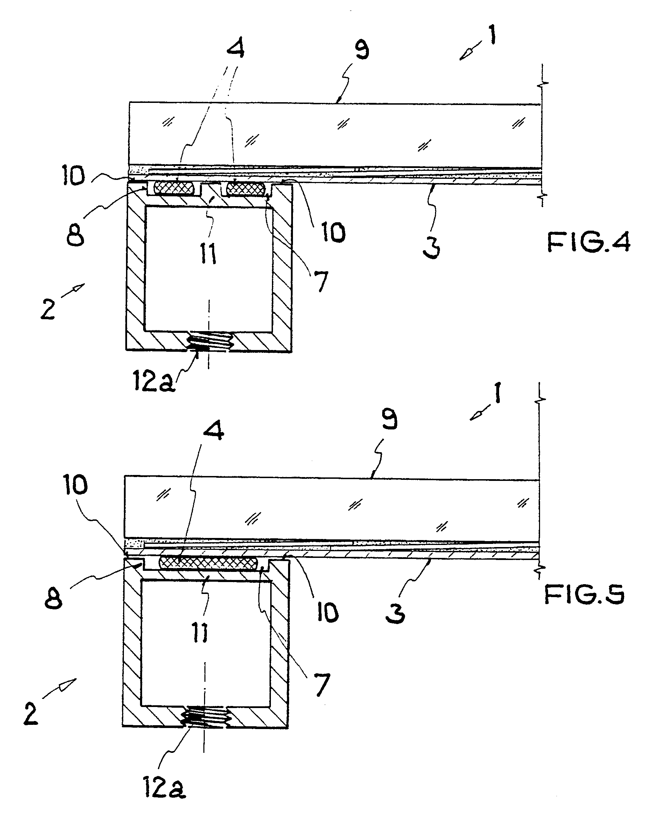

Die Figur 3 zeigt in einer Querschnittsdarstellung eine vorteilhafte Weiterbildung der Ausführungsform gemäß Figur 2. Hierbei ist das Querteil 5 des Rahmenteils 2 U-förmig ausgebildet, und steht mit dieser U-Form auf der Rückseite 3 des Solarzellenlaminats 1 auf. Die Berührungsflächen zwischen diesem Querteil 5 und der Rückseite 3 des Solarzellenlaminats beschränken sich auf die beiden Endflächen 10 der Schenkel des U-förmigen Querteils 5. Der elastische Verbindungssteg 4 befindet sich in der Öffnung 8 dieser U-Form und bildet hierdurch den festen Kontakt zur Rückseite 3 des Solarzellenlaminats 1.

Der Verbindungssteg 4 füllt die Öffnung 8 nicht vollständig aus, so daß beidseitig an dem Verbindungssteg ein Zwischenraum verbleibt. Auch bei dieser Ausführungsform des erfindungsgemäßen Solarzellenmoduls kann sich das Solarzellenlaminat 1 in Abhängigkeit der Elastizität des ebenfalls aus Silikonkleber bestehenden Verbindungssteges 4 gegenüber dem Querteil 5 des Rahmenteils 2 in geringem Maße verschieben, so daß temperaturbedingte, unterschiedliche Längenänderungen der beteiligten Materialien ausgleichbar sind.

Beide Ausführungsbeispiele des erfindungsgemäßen Solarzellenmoduls gemäß den Figuren 2 und 3 enthalten in dem senkrechten Teil 6 des Rahmenteils 2 eine Öffnung 12, die zur weiteren Befestigung auf einer Trägervorrichtung verwendbar ist.

Statt den bei den Ausführungsformen der Erfindung gemäß den Figuren 2 und 3 verwendeten T-förmigen Rahmenteilen 2, können auch Doppel-T-förmige Rahmenteile eingesetzt werden.

Eine weitere bevorzugte Ausführungsform des erfindungsgemäßen Solarzellenmoduls zeigt die Figur 4 einer Querschnittsdarstellung. Dort ist ein rechteckförmiges Profil für das Rahmenteil 2 vorgesehen, wobei ein Seitenteil 11 über dessen äußere Fläche 10 mit der Rückseite 3 des Solarzellenlaminats 1 in Kontakt steht. Auch hier erstreckt sich der Kontaktbereich zwischen Rahmenteil 2 und Solarzellenlaminat 1 nur auf den Rand der Rückseite 3 des Solarzellenlaminats 1. Auf der mit der Rückseite 3 des Solarzellenliniats 1 in Kontakt stehenden Fläche 10 des Seitenteils 11 sind zwei rechteckförmige Aussparungen 7 zur Aufnahme der elastischen Verbindungsstege 4 vorgesehen, wobei die Dimensionierung der Verbindungsstege 4 derjenigen der Verbindungsstege 4 gemäß dem Ausführungsbeispiel der Figur 2 entspricht. Hierdurch erfolgt die feste Verbindung zwischen dem Rahmenteil 2 und dem Solarzellenlaminat 1 nur im Bereich dieser beiden Aussparungen 7, wobei jedoch aufgrund der Elastizität der Verbindungsstege 4 das Solarzellenlaminat 1 gegenüber dem Rahmenteil 2 bewegbar bleibt.

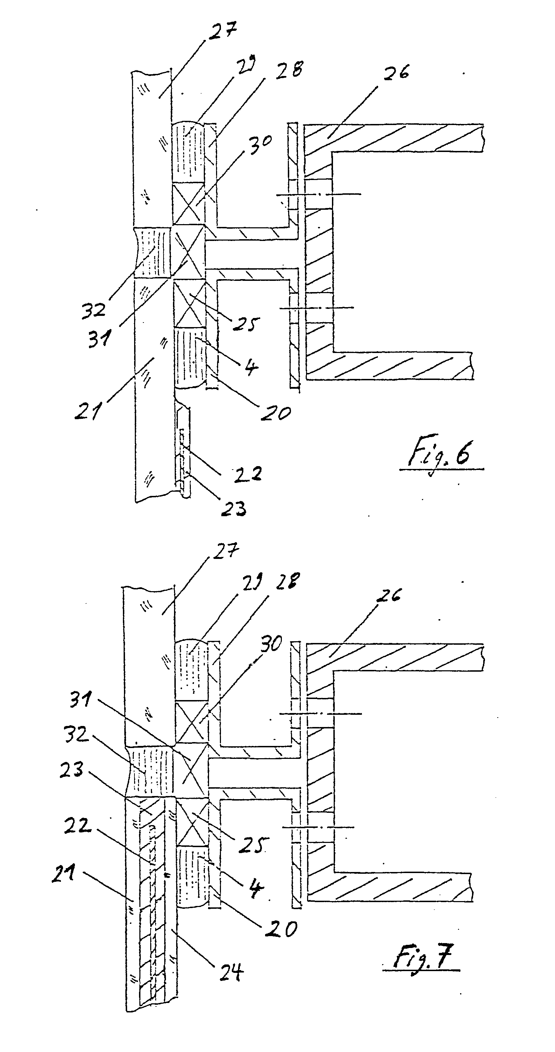

Die Figur 5 zeigt in einer Querschnittsdarstellung eine vorteilhafte Weiterbildung der Ausführungsform des erfindungsgemäßen Solarzellenmoduls gemäß Figur 4. Hierbei ist das mit dem Solarzellenlaminat 1 in kontaktstehende Seitenteil 11 U-förmig ausgebildet und steht mit dieser U-Form auf der Rückseite 3 des Solarzellenlaminats 1, so daß sich das Rahmenteil 2 und das Solarzellenlaminat 1 an den Endflächen 10 der beiden Schenkel berühren. Der elastische Verbindungssteg 4 befindet sich hierbei entsprechend der Ausführungsform der Figur 3 in der Öffnung 8 des U-förmigen Seitenteils 11 des Rahmenteils 2, um hierdurch die feste Verbindung zwischen dem Solarzellenlaminat 1 und dem Rahmenteil 2 sicherzustellen.

Bei den Ausführungsformen der Erfindung gemäß den Figuren 4 und 5 bestehen die elastischen Verbindungsstege 4 ebenfalls aus einer elastischen Klebstoffmasse, beispielsweise aus einem Silikonklebstoff.

Das rechteckförmige Rahmenteil 2 gemäß den Figuren 4 und 5 weist ein Seitenteil auf, das dem Seitenteil 11 gegenüberliegt und eine Gewindeöffnung 12a enthält, die zur weiteren Befestigung auf einer Trägervorrichtung geeignet ist.

Auch bei diesen beiden Ausführungsbeispielen gemäß den Figuren 4 und 5 kann sich das Solarzellenlaminat 1 gegenüber dem Rahmenteil 2 in geringem Maße verschieben, so daß hierdurch Materialspannungen vermeidbar sind. Auch die weiteren Vorteile, die bei den Ausführungsbeispielen gemäß den Figuren 2 und 3 erwähnt wurden, sind bei diesen beiden zuletzt beschriebenen Ausführungsbeispielen gegeben.

Bei den Ausführungsbeispielen gemäß den Figuren 2 bis 5 verbleiben in den die Verbindungsstege 4 aufnehmenden Aussparungn 7 bzw. Öffnungen 8 Zwischenräume, in denen sich während des Betriebes des Solarzellenmoduls Kondenswasser bilden könnte. Um diese unerwünschte Erscheinung zu vermeiden, sind Öffnungen im Rahmenteil 2 vorgesehen, die einen Luftaustausch zwischen diesen Zwischenräumen und der Umgebung zulassen. Diese Öffnungen sind in den Figuren nicht dargestellt.

Wie aus den Figuren 6 und 7 zu ersehen ist, ist der rahmenlos ausgeführte und nur teilweise dargestellte Solargenerator 1a, dessen vordere Glasscheibe mit 21, Solarzellen mit 22, Einbettmasse mit 23 und Trägerplatte mit 24 bezeichnet sind, werksseitig an seiner Rückseite mit einem Befestigungsprofil 20 versehen, das vorzugsweise U-förmig ausgebildet ist. Das Befestigungsprofil 20 ist mit einem Schenkel mittels einer dicken Silikonkleberschicht 4 an dem Solargenerator 1a befestigt, wobei der Abstand zwischen diesen Bauelementen durch einen vorzugsweise elastischen Abstandshalter 25 sichergestellt ist. Mit seinem anderen Schenkel ist das Befestigungsprofil 20 an dem Fassadenpfosten 26 mechanisch befestigt, z. B. mittels nicht dargestellter Schrauben.

Auch die Scheibe 27 ist in gleicher Weise wie der Solarzellengenerator 1a an dem Fassadenpfosten 26 befestigt, nämlich mit einem U-förmigen Befestigungsprofil 28, einem Silikonkleber 29 und einem vorzugsweise elastischen Abstandshalter 30. Alle genannten Befestigungsmittel sind derart bemessen, daß eine ebenflächige Fassade aus Solargenerator 1a und Scheibe 27 entsteht. In der zwischen dem Solargenerator 1a und der Scheibe 27 bestehenden Fuge sind ein weiterer Abstandshalter 31, der elastisch ausgeführt sein kann, und eine Dichtungsmasse 32 eingefügt. Eine derartige Anordnung von wechselnden Fensterscheiben und Solargeneratoren ist typischerweise an einem Hochhaus gegeben für den Fenster- und Brüstungsbereich.

## Ansprüche

1. Photovoltaischer rahmenloser Solargenerator, vorzugsweise für eine Hochhausfassade, ein Dach, einen Wintergarten oderdergleichen, der in Kunststoff eingebettete Solarzellen, insbesondere Solarzellenlaminat, und als Abdeckung eine Glasscheibe aufweist, dadurch gekennzeichnet, daß der Solargenerator (1, 1a) an seiner Rückseite (3, 24, 21) werksseitig mit Befestigungsprofilen (2, 20) versehen ist, und daß die Verbindung zwischen der Rückseite (3, 24, 21) und den Befestigungsprofilen (2, 20) über elastische Verbindungsstege (4) erfolgt.

2. Solargenerator nach Anspruch 1, dadurch gekennzeichnet, daß die Befestigungsprofile (2, 20) auf die Rückseite des Solargenerators (1, 1a) aufgeklebt sind.

3. Solargenerator nach Anspruch 1 oder 2, dadurch gekennzeichnet, daß zwischen der Rückseite (3) des Solargenerators (1, 1a) und den Befestigungsprofilen (2, 20) Abstandshalter (25) angeordnet sind.

4. Solargenerator nach Anspruch 3, gekennzeichnet durch elastische Abstandshalter (25, 30, 31).

5. Solargenerator nach Anspruch 1, 2, 3 oder 4, gekennzeichnet durch U-förmige Befestigungsprofile (2, 20), deren gegenüberliegende Schenkel an dem Solargenerator (1, 1a) oder der Fassade oderdergleichen befestigt sind.

6. Solargenerator nach Anspruch 1, 2, 3 oder 4, gekennzeichnet durch L-förmige Befestigungsprofile.

7. Solargenerator nach Anspruch 1, 2, 3, 4, 5 oder 6, dadurch gekennzeichnet, daß die Fugen zwischen Solargeneratoren (1a) und/oder Scheiben (27) der Hochhausfassade, des Daches, des Wintergartens oderdergleichen mit einem Abstandshalter (31) und/oder einer Dichtmasse (32) ausgefüllt sind.

8. Solargenerator nach Anspruch 7, gekennzeichnet durch die Verwendung von Silikonklebern als Dichtmasse.

9. Solargenerator nach Anspruch 1, dadurch gekennzeichnet, daß das Befestigungsprofil (2) als T-Profil ausgebildet ist, daß die Fläche (10) des Querteils (5) des T-förmigen Rahmenteils (2), die derjenigen, die mit dem senkrechten Teil (6) des T-förmigen Rahmenteils (2) verbunden ist, gegenüberliegt, mit der Rückseite (3) des Solarzellenlaminats (1) in Kontakt steht.

10. Solargenerator nach Anspruch 9, dadurch gekennzeichnet, daß die Fläche (10) des Querteils (5) des T-förmigen Rahmenteils (2), die mit der Rückseite (3) des Solarzellenlaminats (1) in Kontakt steht, Aussparungen (7) aufweist, und daß diese Aussparungen (7) die elastischen Verbindungsstege (4) zur Verbindung mit dem Solarzellenlaminat (1) aufnehmen.

11. Solargenerator nach Anspruch 9, dadurch gekennzeichnet, daß das Querteil (5) des T-förmigen Rahmenteils (2) derart U-förmig ausgebildet ist, daß jeweils die Endfläche (10) der beiden Schenkel dieses U-förmigen Querteils (5) mit der Rückseite (3) des Solarzellenlaminats (1) in Kontakt steht, und daß in der im Bereich der Öffnung (8) des U-förmigen Querteils (5) angeordnete elastische Verbindungssteg (4) die Verbindung zum Solarzellenlaminat (1) herstellt.

12. Solargenerator nach Anspruch 1, dadurch gekennzeichnet, daß das Befestigungsprofil (2) ein rechteckförmiges Profil aufweist.

13. Solargenerator nach Anspruch 12, dadurch gekennzeichnet, daß die mit der Rückseite (3) des Solarzellenlaminats (1) in Kontakt stehende Fläche (10) des Rahmenteils (2) Aussparungen (7) aufweist, und daß die Aussparungen (7) die elastischen Verbindungsstege (4) zur Verbindung mit dem Solarzellenlaminat (1) aufnehmen.

14. Solargenerator nach Anspruch 10 oder 13, dadurch gekennzeichnet, daß die Breite der elastischen Verbindungsstege (4) jeweils kleiner ist als die Breite der zugehörigen Aussparungen (7), und daß die elastischen Verbindungsstege (4) jeweils derart in der zugehörigen Aussparung (7) angeordnet ist, daß beidseitig an den Verbindungsstegen (4) jeweils ein Zwischenraum verbleibt.

15. Solargenerator nach Anspruch 12, dadurch gekennzeichnet, daß das mit der Rückseite (3) des Solarzellenlaminats (1) in Kontakt stehende Seitenteil (11) des Rahmenteils (2) U-förmig ausgebildet ist, daß jeweils die Endfläche (10) der beiden Schenkel dieses U-förmigen Seitenteils (11) mit der Rückseite (3) des Solarzellenlaminats (1) in Kontakt steht, und daß der im Bereich der Öffnung (8) des U-förmigen Seitenteils (11) angeordnete elastische Verbindungssteg (4) die Verbindung zum Solarzellenlaminat (1) herstellt.

16. Solargenerator nach Anspruch 11 oder 15, dadurch gekennzeichnet, daß die Breite des elastischen Verbindungssteges (4) kleiner ist als die Breite der Öffnung (8), und daß der elastische Verbindungssteg (4) derart in die Öffnung (8) angeordnet ist, daß beidseitig an dem Verbindungssteg (4) ein Zwischenraum verbleibt.

17. Solargenerator nach einem der vorangehenden Ansprüche 9 bis 16, dadurch gekennzeichnet, daß der Kontaktbereich zwischen der Fläche (10) des Rahmenteils (2) und der Rückseite (3) des Solarzellenmoduls (1) nur im Bereich des Randes der Rückseite (3) vorgesehen ist.

18. Solargenerator nach einem der vorangehenden Ansprüche 9 bis 17, dadurch gekennzeichnet, daß der elastische Verbindungssteg (4) aus einer elastischen Klebstoffmasse besteht.

19. Solargenerator nach Anspruch 18, dadurch gekennzeichnet, daß die elastische Klebstoffmasse aus einem Silikonkleber (4, 29) besteht.

FIG.1

FIG.2

FIG.3

FIG.4

FIG.5

_Fig. 6_

_Fig. 7_